# EUROPÄISCHE PATENTANMELDUNG

(11) **EP 1 289 031 A2**
(43) Veröffentlichungstag der Anmeldung: **05.03.2003**
(21) Anmeldenummer: 02400038.2
(22) Anmeldetag: 21.08.2002
(51) Int. Cl.: H01L 51/40

(54) **Verfahren zur Herstellung eines leitfähigen strukturierten Polymerfilms**

(30) Priorität: 24.08.2001 DE 10140666
(71) Anmelder: Technische Universität Braunschweig, 38106 Braunschweig (DE)
(72) Erfinder: Becker, Eike, 38106 Braunschweig (DE); Johannes, Hans-Hermann, 38159 Vechelde (DE); Kowalsky, Wolfgang, 38116 Braunschweig (DE)
(74) Vertreter: Enders, Monika Ute

(57) **Zusammenfassung**

Es wird eine zweischichtige Anode (1') zur elektrochemischen Polymerisation verwendet. Die untere Schicht (2) besteht aus einem nichtleitfähigen Trägermaterial, auf das eine leitfähige Elektrodenschicht (3') aufgebracht ist, die in Teilbereichen zur Bildung von nichtleitfähigen Bereichen entfernt ist. Die nichtleitfähigen Bereichen haben eine vorgegebene Struktur, die der Struktur des zu bildenden strukturierten Polmerfilms (11) entspricht. Die Anode (1') wird zusammen mit einer Platinkathode in einen Elektrolyten gehalten, in den niedermolekulare Verbindungen, vorzugsweise Monomere des zu bildenden Polymerfilms (11) eingebracht sind. Über Anode (1') und Kathode wird ein Stromfluß durch den Elektrolyten erzeugt. Dabei wird auf den mit dem Elektrolyten in Kontakt gebrachten leitfähigen Bereichen ein leifähiger Polymerfilm (11) der vorgegebenen Struktur gebildet. Auf den strukturierten Polymerfilm (11) wird eine nichtleitfähige Substratschicht (13) aufgebracht, an der der strukturierte Polymerfilm (11) haftet. Der strukturierte Polymerfilm (11) läßt sich mit der nichtleitfähigen Substratschicht (13) problemlos von der Elektrode (1') lösen. Die Elektrode wird dabei nicht beschädigt und kann anschließend sofort wieder zur Abschaltung eines neuen strukturierten Polymerfilms verwendet werden. Auf diese Weise können leitfähige strukturierte Polymerfilme mit hoher Auflösung äußerst kostengünstig und in Massenproduktion hergestellt werden.

## Beschreibung

Die Erfindung betrifft ein Verfahren zur Herstellung eines leitfähigen strukturierten Polymerfilms.

Derartige leitfähige strukturierte Polymerfilme werden zur Herstellung von integrierten Schaltungen der Polymerelektronik verwendet. Beispielsweise können Feldeffekt-Transistoren aus polymeren Leiterstrukturen aufgebaut werden. Bei derartigen Feldeffekt-Transistoren muß der zwischen der Source-Elektrode und der Drain-Elektrode vorgesehene Kanal eine Länge im Bereich unterhalb von 10 µm haben, da die in den Kanal eingebrachten organischen Halbleitermaterialien geringe Ladungsträgerbeweglichkeiten aufweisen.

Es ist geplant, strukturierte Polymerfilme als Massenartikel, beispielsweise für intelligente Warenhausetiketten oder für intelligente Güteretiketten zur Überwachung des Gütertransports herzustellen. Hierfür ist es erforderlich, daß die Herstellung äußerst kostengünstig ist.

Bisher sind verschiedene Verfahren zur Herstellung von polymeren Leiterstrukturen bekannt. Beispielsweise können polymere Leiterbahnen mit Hilfe bekannter Druckverfahren wie Siebdruck oder Tampoon-Druck oder mit Hilfe des Prinzips des Tintenstrahldruckens hergestellt werden. Allerdings kann mit diesen Druckverfahren nur eine geringe Auflösung erzielt werden. Daher sind sie beispielsweise zur Herstellung von polymeren Feldeffekt-Transistoren nicht geeignet. Außerdem erfordern diese Druckverfahren, daß die verwendeten leitfähigen Polymere in einem leichtflüchtigen Lösungsmittel lösbar sind. Daher ist die Zahl der für die bekannten Druckverfahren geeigneten Polymere beschränkt.

Es ist ferner eine Modifikation dieser Druckverfahren bekannt, mit der eine höhere Auflösung erzielbar ist. Bei diesem modifizierten Druckverfahren wird das Substrat vorstrukturiert, indem ausgewählte Bereiche hydrophil, die anderen Bereiche hydrophob gemacht werden. Der Druck erfolgt dann mit einer wäßrigen Lösung eines leitfähigen Polymers, die sich nur auf den hydrophilen Bereichen verteilt. Auch bei diesem Verfahren können nur lösliche leitfähige Polymere verwendet werden. Ferner hat auch dieses Verfahren den Nachteil, daß das Substrat vorstrukturiert werden muß. Die Kosten hierfür sind beträchtlich. Daher ist dieses Verfahren nicht geeignet für eine Massenproduktion von strukturierten Polymerfilmen.

Ferner ist es bekannt, ein Substrat zunächst ganzflächig mit einem elektrisch leitfähigen Polymer zu beschichten, wobei dem Polymer ein Photoinitiator beigemischt wird. Durch anschließende Belichtung der Polymerschicht mit UV-Licht durch eine Maske können isolierende Bereiche in dem leitfähigen Polymerfilm erzeugt werden. Dieses Verfahren hat den Nachteil, daß zunächst das ganze Substrat mit dem leitfähigen Polymer beschichtet werden muß, obwohl zum Schluß nur eine kleiner Teil als leitfähige Struktur genutzt wird. Dies ist sehr kostspielig, da die leifähigen Polymere einen erheblichen Kostenfaktor darstellen.

Bei einem weiteren ähnlichen Verfahren werden die elektrischen Eigenschaften eines ganzflächig auf ein Substrat aufgebrachten leitfähigen Polymerfilms dadurch selektiv verändert, daß eine ionenhaltige Flüssigkeit selektiv aufgebracht oder der leitfähige Polymerfilm selektiv erhitzt wird. Auch dieses Verfahren ist aufgrund des ganzflächig aufgebrachten leitfähigen Polymerfilms kostenaufwendig und für eine Massenproduktion nicht geeignet.

Schließlich beschreibt die WO 97/18944 ein auf der bekannten Photolithographie-Technik beruhendes Verfahren zur Herstellung eines strukturierten Polymerfilms. Dabei wird wiederum ganzflächig eine leitfähige Polymerschicht auf eine Substratschicht aufgebracht, wobei auf die Polymerschicht ein Photolack aufgetragen wird, der durch einer Maske belichtet wird. Die belichteten Bereiche der Photolackschicht werden entfernt. Danach wird das leitfähige Polymer in den nicht mehr abgedeckten Bereichen weggeätzt. Auch bei diesem Verfahren wird eine leitfähige Polymerschicht ganzflächig aufgebracht. Der Materialverbrauch und die Kosten hierfür sind entsprechend hoch. Außerdem ist das Verfahren sehr aufwendig, da vier Prozeßschritte erforderlich sind.

Aufgabe der Erfindung ist es, bei geringen Herstellungskosten eine hohe Auflösung von leitfähigen strukturierten Polymerfilmen zu ermöglichen.

Gelöst wird diese Aufgabe erfindungsgemäß dadurch,
a) daß eine Elektrode verwendet wird, deren Oberfläche leitfähige Bereiche einer vorgegebenen Struktur und nichtleitfähige Bereiche aufweist,
b) daß wenigstens ein Teil der leitfähigen Bereiche in Kontakt mit einem Elektrolyten gebracht wird, wobei in den Elektrolyten niedermolekulare Verbindungen, vorzugsweise Monomere, eingebracht sind,
c) daß über die Elektrode ein Stromfluß durch den Elektrolyten erzeugt wird, wobei auf den mit dem Elektrolyten in Kontakt gebrachten leitfähigen Bereichen ein leitfähiger Polymerfilm der vorgegebenen Struktur gebildet wird, und
d) daß danach der gebildete strukturierte Polymerfilm von der Elektrode entfernt wird.

Durch die Erfindung gelingt es erstmalig, leitfähige strukturierte polymere Filme mit hoher Auflösung kostengünstig herzustellen. Die Elektrode wird nur ein einziges Mal bei der Herstellung auf ihrer Oberfläche mit leitfähigen Bereichen einer vorgegebenen Struktur versehen und kann danach beliebig oft zur Abscheidung eines leitfähigen Polymerfilms der vorgegebenen Struktur verwendet werden. Für die leitfähigen Bereiche der Elektrode sollte ein Material gewählt werden, an dem das abzuscheidende Polymer hinreichend gut, aber nicht zu stark haftet. Da die Strukturierung der Oberfläche der Elektrode nur einmal erforderlich ist, können beliebige, auch kostspielige, bekannte Verfahren für die Strukturierung eingesetzt werden. Der Kostenbeitrag zu den Gesamtherstellungskosten für einen leitfähigen strukturierten Polymerfilm ist bei einer Massenproduktion von gleichen Polymerfilmen aufgrund der Wiederverwendbarkeit der Elektrode vernachlässigbar.

Ferner hat das Verfahren den Vorteil, daß nur dort ein leitfähiges Polymer abgeschieden wird, wo es aufgrund der Struktur tatsächlich erforderlich ist. Der Materialverbrauch und die entsprechenden Kosten bei der Herstellung des leitfähigen Polymerfilms können somit auf ein Minimum beschränkt werden. Als niedermolekulare Verbindungen können nicht nur Monomere, sondern auch Dimere oder andere kurzkettige Grundbausteine von Polymeren in den Elektrolyten eingebracht werden. Es können auch verschiedene Arten von niedermolekularen Verbindungen kombiniert werden. Ihre Auswahl richtet sich nach dem zu erzeugenden Polymermaterial. Die Monomere oder anderen niedermolekularen Verbindungen werden auf den leitfähigen Bereichen abgeschieden, wobei eine elektrochemische Polymerisation erfolgt. Der gebildete Polymerfilm wird beim Abscheiden durch Ionen des Elektrolyten dotiert, so daß er leitfähig wird.

Der strukturierte Polymerfilm kann auf beliebige Weise von der Elektrode entfernt werden. Die Elektrode wird weder durch den Abscheideprozeß noch durch das Entfernen des strukturierten Polymerfilms angegriffen oder beschädigt. Daher kann sie sofort zur Herstellung des nächsten leitfähigen strukturierten Polymerfilms verwendet werden. Der Elektrolyt kann mehrfach bis zur Erschöpfung der darin eingebrachten niedermolekularen Verbindungen, beispielsweise eines bestimmten Monomers, verwendet oder schrittweise bzw. kontinuierlich regeneriert werden.

Ein besonderer Vorteil des erfindungsgemäßen Herstellungsverfahrens ist, daß anders als bei vielen bekannten Verfahren auch nicht lösliche Polymere hergestellt werden können. Dies schafft einen zusätzlichen Handlungsspielraum für die weiteren Prozeßschritte zur Herstellung einer integrierten Polymerschaltung. Vorteilhaft ist ferner, daß das erfindungsgemäße Verfahren lediglich naßchemisch arbeitet und nur zwei Schritte umfaßt. Daher lassen sich leitfähige strukturierte Polymerfilme mit ihm schnell und einfach herstellen. Aufgrund des zusätzlich eingesparten Materials ist der Kostenvorteil gegenüber bekannten Verfahren enorm.

Eine bevorzugte Ausführungsform ist dadurch gekennzeichnet, daß beim Schritt d) der strukturierte Polymerfilm auf eine Substrat übertragen wird. Vorteilhafterweise wird zum Übertragen des strukturierten Polymerfilms auf das Substrat auf die Elektrode polymerfilmseitig großflächig, vorzugsweise den gesamten strukturierten Polymerfilm abdeckend, eine nichtleitfähige Substratschicht aufgebracht, wobei die Substratschicht so ausgewählt wird, daß der strukturierte Polymerfilm an ihr haftet oder sie mit diesem thermisch oder photochemisch verklebbar ist. Für die nichtleitfähigen Bereiche sollte ein Material gewählt werden, an dem die Substratschicht, auf die der strukturierte Polymerfilm übertragen wird, nicht zu stark haftet. Für das photochemische Verkleben bieten sich Klebstoffe an, die bei Bestrahlung mit ultraviolettem Licht aushärten. Solche Klebstoffe sind kommerziell erhältlich.

Eine Weiterbildung des Verfahrens ist dadurch gekennzeichnet, daß zur Bildung der nichtleitfähigen Substratschicht eine Lösung aus einem in einem flüchtigen Lösungsmittel gelösten nichtleitfähigen Polymer aufgebracht wird, daß das Lösungsmittel in den gasförmigen Aggregatzustand überführt wird und daß anschließend der an der Substratschicht haftende strukturierte Polymerfilm von der Elektrode abgezogen wird. Die Überführung in den gasförmigen Aggregatzustand kann durch Verdunstung oder durch Verdampfen erfolgen.

Eine bevorzugte Ausführungsform der Erfindung ist dadurch gekennzeichnet, daß eine flexible Sustratschicht verwendet wird, die eine Dicke von 50 µm bis 1 mm, vorzugsweise von 0,4 bis 0,6 mm hat. Die Verwendung einer flexiblen und derart dünnen Substratschicht hat den Vorteil, daß sie sich besonders gut an den gebildeten strukturierten Polymerfilm anschmiegen kann. Darüber hinaus ermöglicht eine flexible Substratschicht eine einfache und automatisierbare Herstellung. Die flexible Substratschicht kann als Bahn von einer Vorratsrolle abgewickelt werden und nach dem Aufbringen eines oder mehrerer strukturierter Polymerfilme auf eine Aufwickelrolle aufgewickelt werden.

Je nach Anwendungsgebiet kann es vorteilhaft sein, auf die dem strukturierten Polymerfilm abgewandte Seite der Substratschicht eine Stabilisierungsschicht aufzubringen und die Stabilisierungsschicht mit der Substratschicht thermisch oder photochemisch zu verkleben. Selbstverständlich kann auch die Stabilisierungsschicht als flexible Bahn ausgeführt werden und nach dem Verkleben mit einer flexiblen Substratschicht mit dieser zusammen und dem darauf aufgebrachten strukturierten Polymerfilm aufgewickelt werden.

Eine wichtige Ausführungsform der Erfindung ist dadurch gekennzeichnet, daß die leitfähigen und/oder nichtleitfähigen Bereiche so strukturiert werden, daß wenigstens ein Teil ihrer lateralen Abmessungen unterhalb von 50 µm, vorzugsweise unterhalb von 10 µm liegt.

Eine Weiterbildung der Erfindung ist dadurch gekennzeichnet, daß eine wenigstens zweischichtige Elektrode verwendet wird, bei deren Herstellung auf eine untere Schicht aus einem nichtleitfähigen Trägermaterial eine leitfähige Elektrodenschicht ganzflächig aufgebracht wird, die in Teilbereichen zur Bildung der nichtleitfähigen Bereiche entfernt wird.

Eine hohe Auflösung bei der Herstellung der leitfähigen Bereiche der vorgegebenen Struktur kann dadurch erzielt werden, daß die leitfähigen und nichtleitfähigen Bereiche mit einem photolithografischen Verfahren erzeugt werden.

Alternativ kann eine wenigstens dreischichtige Elektrode verwendet werden, wobei die untere Schicht aus einem Trägermaterial besteht, auf das eine leitfähige Elektrodenschicht ganzflächig aufgebracht ist, und wobei die leitfähige Elektrodenschicht in Teilbereichen zur Bildung der nichtleitfähigen Bereiche mit einer Isolatorschicht abgedeckt ist. Das Material der Isolatorschicht sollte so gewählt werden, daß die Substratschicht nicht zu sehr an ihr haftet.

Vorzugsweise wird der Stromfluß im Schritt c) dadurch erzeugt wird, daß die leitfähigen Bereiche auf der Elektrode elektrisch kontaktiert werden und über eine Strom- oder Spannungsquelle mit einer Gegenelektrode verbunden werden, und daß wenigstens ein Teil der Oberfläche der Gegenelektrode in Kontakt mit dem Elektrolyten gebracht wird. Die Filmdicke kann durch Messung der transportierten elektrischen Ladung kontrolliert werden. Bei Erreichen der gewünschten Filmdicke wird die Spannung abgeschaltet und die Elektrode aus dem Elektrolyten genommen.

Es hat sich gezeigt, daß der gebildete strukturierte Polymerfilm dadurch besonders homogen wird, daß mit der Spannungsquelle eine Spannung zwischen 1 und 100 Volt, vorzugsweise von 10 Volt zwischen Elektrode und Gegenelektrode angelegt wird.

Bei einem bevorzugten Ausführungsbeispiel wird die Elektrode als Anode und die Gegenelektrode als Kathode geschaltet. Die Kathode sollte aus einem Material bestehen, das zur Durchführung der Elektropolymerisation geeignet ist.

Eine Weiterbildung der Erfindung ist dadurch gekennzeichnet, daß eine Elektrode und/oder Gegenelektrode verwendet wird, die Glas als Trägermaterial enthält. Die Materialkosten hierfür sind gering. Außerdem ermöglicht die Verwendung von Glas eine allseitige visuelle Kontrolle des elektrochemischen Prozesses.

Vorzugsweise wird eine Elektrode mit einer leitfähigen Elektrodenschicht aus Indium-Zinnoxid verwendet. Es hat sich bewährt, daß wenigstens der mit dem Elektrolyten in Kontakt gebrachte Teil der Oberfläche der Kathode aus Platin oder Gold besteht. Beispielsweise kann auf eine Trägerschicht aus Glas ein dünner Platinfilm aufgedampft werden.

Eine Weiterbildung der Erfindung ist dadurch gekennzeichnet, daß als niedermolekulare Verbindungen Pyrrole, 3-Alkylpyrrole, insbesondere 3-Methyl-, 3-Ethyl-, 3-Propylpyrrole, *N*-Alkylpyrrole, insbesondere *N*-Methyl-, *N*-Ethyl-, *N*-Propylpyrrole, *N*-Arylpyrrole, insbesondere *N*-Phenyl-, *N*-(4-Amino)phenyl-, *N*-(4-Methoxy)phenyl-, *N*-Naphtylpyrrole, *N*-Heteroarylpyrrole, insbesondere *N*-(3-Thienyl)-, *N*-(2-Thienyl)-, *N*-(3-Furanyl)-, *N*-(2-Furanyl)-, *N*-(3-Selenophenyl)-. *N*-(2-Selenophenyl)-, *N*-(3-Pyrrolyl)pyrrole, Thiophene, 3-Alkylthiophene, insbesondere 3-Methyl-, 3-Ethyl-, 3-Propylthiophene, Furane, 3-Alkylfurane, 3-Methyl-, 3-Ethyl-, 3-Propylfurane, Selenophene, 3-Alkylselenophene, insbesondere 3-Methyl-, 3-Ethyl-, 3-Propylselenophene, Tellurophene, Aniline, Biphenyle, Azulene, 2-(alpha-Thienyl)thiophene, 2-(alpha-(3-Alkyl)thienyl)thiophene, 2-(alpha-(3-Alkyl)thienyl)-(3-alkyl)thiophene, 2-(alpha-Thienyl)furane, 2-(alpha-(3-Alkyl)thienyl)furane, 2-(alpha-(3-Alkyl)thienyl)-(3-alkyl)furane, 2- (alpha-Thienyl) - (3-alkyl)furane, 2-(alpha-Thienyl)pyrrole, 2-(alpha-(3-Alkyl)thienyl)pyrrole, 2-(alpha-(3-Alkyl)thienyl)- (3-alkyl)pyrrole, 2-(alpha-Thienyl)-(3-alkyl)pyrrole, 2-(alpha-Furanyl)pyrrole, 2-(alpha-(3-Alkyl)furanyl)pyrrole, 2-(alpha-(3-Alkyl)furanyl)-(3-alkyl)pyrrole, 2-(alpha-Furanyl)-(3-alkyl)pyrrole, 2-(alpha-Pyrrolyl)pyrrole, 2-(alpha-(3-Alkyl)pyrrolyl)pyrrole, 2-(alpha-(3-Alkyl)pyrrolyl) - (3-alkyl)pyrrole, 2-(alpha-pyrrolyl)-(3-alkyl)pyrrole, 2-(alpha-Selenophenyl)selenophene, 2-(alpha-(3-Alkyl)selenophenyl)selenophene, 2-(alpha-(3-Alkyl)selenophenyl)-(3-alkyl)selenophene, 2-(alpha-Thienyl) selenophene, 2-(alpha-(3-Alkyl)thienyl)selenophene, 2-(alpha-(3-Alkyl)thienyl)-(3-alkyl)selenophene, 2-(alpha-Thienyl)-(3-alkyl)selenophene, 2-(alpha-Selenophenyl)furane, 2- (alpha- (3-Alkyl) selenophenyl) furane, 2- (alpha- (3-Alkyl)selenophenyl)-(3-alkyl)furane, 2-(alpha-Selenophenyl)-(3-alkyl)furane, 2-(alpha-Selenophenyl)pyrrole, 2-(alpha-(3-Alkyl)selenophenyl)pyrrole, 2-(alpha-(3-Alkyl)selenophenyl)-(3-alkyl)pyrrole, 2-(alpha-Selenophenyl) - (3-alkyl)pyrrole, Thienothiophene, Thienofurane, Thienoselenophene, Thienopyrrole, 2-Phenylthiophene, 2-Phenylfurane, 2-Phenylpyrrole, 2-Phenylselenophene, 2-Phenyltellurophene, *N*-Vinylcarbazol, *N*-Ethynylcarbazol, 3,4-Ethylendioxythiophene, 2-(alpha-(3,4-Ethylendioxy)thienyl)thiophene, 2-(alpha-(3,4-Ethylendioxy)thienyl)-3,4-Ethylendioxythiophene, 2-(alpha-(3,4-Ethylendioxy)thienyl)-(3-alkyl)thiophene, 2-(alpha-(3,4-Ethylendioxy)thienyl)furane, 2-(alpha-(3,4-Ethylendioxy)thienyl)-(3-alkyl)furane, 2-(alpha-(3,4-Ethylendioxy)thienyl)pyrrole, 2-(alpha-(3,4-Ethylendioxy)thienyl)-(3-alkyl)pyrrole, 2-(alpha-(3,4-Ethylendioxy)thienyl)selenophene oder 2-(alpha-(3,4-Ethylendioxy)thienyl)-(3-alkyl)selenophene jeweils einzeln oder in beliebiger Kombination oder als oligomere Monomereinheiten verwendet werden.

Ein geeigneter Elektrolyt kann dadurch hergestellt werden, daß ein vorzugsweise organisches Lösungsmittel verwendet wird, in dem ein Salz gelöst wird. Dabei ist der Elektrolyt so auszuwählen, daß auch die niedermolekularen Verbindungen darin gut löslich sind. Ferner muß das Lösungsmittel eine elektrochemische Polymerisation ermöglichen.

Da der gebildete strukturierte Polymerfilm beim Abscheiden durch Ionen des Elektrolyten dotiert wird, beeinflußt der Elektrolyt die Materialeigenschaften des strukturierten Polymerfilms direkt. Die Leitfähigkeit des strukturierten Polymerfilms hängt stark von der Menge der Ionen im Polymerfilm ab. Um die Leitfähigkeit des Polymerfilms zu verringern oder zu erhöhen, kann die mit dem strukturierten Polymerfilm beschichtete Elektrode nach der Polymerisation zusammen mit einer zweiten Gegenelektrode in einen zweiten Elektrolyten getaucht werden, der neben dem Lösungsmittel nur das Salz, d.h. keine Monomere enthält. Die zweite Gegenelektrode kann aus dem gleichen oder einem ähnlichen Material wie die erste Gegenelektrode bestehen. Die erste Gegenelektrode kann auch als zweite Gegenelektrode verwendet werden. Durch Anlegen einer Spannung zwischen Elektrode und zweiter Gegenelektrode kann die Menge der Ionen im strukturierten Polymerfilm verändert werden. Bei einer Spannung in umgekehrter Richtung im Vergleich zur Polymerisation wird die Menge der Ionen verringert. Damit sinkt die Leitfähigkeit und der strukturierte Polymerfilm wird nahezu isolierend. Bei einer Spannung in gleicher Richtung wie bei der Polymerisation wird die Menge der Ionen im Polymerfilm erhöht und die Leitfähigkeit steigt möglicherweise an. Sie ist durch die elektrischen Eigenschaften des Polymers jedoch begrenzt.

Es hat sich gezeigt, daß bei Verwendung eines organischen Lösungsmittels sich der abgeschiedene strukturierte Polymerfilm besonders leicht von der Elektrode lösen läßt.

Vorteilhafterweise wird als Lösungsmittel Propylencarbonat, Acetonitril, ein- oder mehrwertige Alkohole, Tetrahydrofuran oder Wasser jeweils einzeln oder in beliebiger Mischung verwendet.

Gute Polymerisationsergebnisse können dadurch erzielt werden, daß als Salz Tetraethylammonium-tetrafluoroborat, Tetraethylammonium-hexafluorophosphat, Tetraethylammoniumperchlorat oder Poly(styrolsulfonsäure)-Natriumsalz jeweils einzeln oder in beliebiger Kombination verwendet wird.

In bevorzugter Ausführungsform wird ein strukturierter Polymerfilm eine Dicke von 0,1 bis 2 µm vorzugsweise von 0,4 bis 0,6 µm erzeugt.

Die wirtschaftlich günstigste Herstellung des leitfähigen strukturierten Polymerfilms besteht darin, daß eine rotierbare vorzugsweise keiszylinderförmige Elektrode verwendet wird, daß die Elektrode so angeordnet wird, daß die leitfähigen Bereiche bei der Rotation in den Elektroklyten eintauchen und anschließend aus dem Elektrolyten herausbewegt werden.

Bei Verwendung einer rotierbaren Elektrode läßt sich das Herstellungsverfahren besonders einfach automatisieren, wodurch eine kontinuierliche bzw. quasi-kontinuierliche Herstellung möglich wird. Die Elektrode kann entweder schrittweise gedreht werden, wobei jeweils gleichzeitig der untere Bereich der Elektrode in den Elektrolyten eintaucht und von dem oberen Bereich der Elektrode ein bereits fertiger strukturierter leitfähiger Film entfernt werden kann. Sobald eine genügend dicke leitfähige Polymerschicht auf den im Elektrolyten angeordneten leitfähigen Bereich abgeschieden ist, kann die Elektrode so weit gedreht werden, daß der nächste Abschnitt der Elektrode mit leitfähigen Bereichen in den Elektrolyten eintaucht und gleichzeitig ein weiterer fertiger strukturierter Polymerfilm im oberen Bereich von der Elektrode entfernt werden kann. Selbstverständlich kann die Drehung der Elektrode statt schrittweise auch kontinuierlich erfolgen. Als rotierbare Elektrode kann auch ein umlaufendes Elektrodenband verwendet werden, welches in dem unteren Bereich in den Elektolyten eintaucht und in dem oberen Bereich aus dem Elektrolyten hinausragt.

Eine wesentliche Weiterbildung ist dadurch gekennzeichnet, daß wenigstens ein Teil des auf der Elektrode gebildeten strukturierten Polymerfilms nach dem Schritt c) in Kontakt mit einer Lösung aus einem Metallsalz gebracht wird, daß über die Elektrode ein Stromfluß durch die Lösung aus dem Metallsalz erzeugt wird, wobei auf dem mit der Lösung aus dem Metallsalz in Kontakt gebrachten strukturierten Polymerfilm ein Metallfilm gebildet wird. Durch Verwendung des strukturierten Polymerfilms als "Zwischenschicht" zwischen Elektrode und Metallfilm kann der Metallfilm problemlos von der Elektrode entfernt werden. Ohne Zwischenschicht würde der Metallfilm sehr stark an der Elektrode haften. Die Elektrode kann wiederverwendet werden. Das Verfahren ermöglicht eine kontinuierliche Herstellung von großen Mengen von strukturierten Metallfilmen. Vorzugsweise wird vor dem Schritt d) auf den Metallfilm auf der dem strukturierten Polymerfilm abgewandten Seite ein Substrat aufgebracht. Der Metallfilm kann dazu bspw. mit einem geeigneten Substrat verklebt werden. Je nach gewünschter Anwendung kann der leitfähige strukturierte Polymerfilm danach entfernt werden. Bei Verwendung einer Kunststofffolie als Substrat können mit diesem Verfahren mit fein strukturierten Metallfilmen beschichtete Kunststoffolien hergestellt werden.

Eine bevorzugte Verwendung des erfindungsgemäßen Verfahrens ist die Herstellung einer Source- und Drain-Elektrode wenigstens eines Feldeffekt-Transistors enthaltenden Leiterstruktur.

Zur Erfindung gehört auch eine Anordnung zur Herstellung eines leitfähigen strukturierten Polymerfilms, die gekennzeichnet ist durch
a) eine Elektrode und eine Gegenelektrode, wobei die Oberfläche der Elektrode leitfähige Bereiche einer vorgegebenen Struktur und nichtleitfähige Bereiche aufweist,
b) ein einen Elektrolyten enthaltenden Behälter, wobei die Elektrode und die Gegenelektrode so angeordnet sind, daß wenigstens ein Teil der leitfähigen Bereiche der Elektrode und ein Teil der Oberfläche der Gegenelektrode in Kontakt mit dem Elektrolyten gebracht werden können,
   wobei der Elektrolyt niedermolekulare Verbindungen, vorzugsweise Monomere, enthält,
c) eine mit der Elektrode und der Gegenelektrode elektrisch verbundene Strom- oder Spannungsquelle zum Erzeugen eines Stromflusses durch den Elektrolyten. Der Aufbau der erfindungsgemäßen Anordnung ist einfach und ermöglicht eine leichte Handhabung. Mit ihm lassen sich leitfähige strukturierte Polymerfilme als Massenproduktion schnell und äußerst kostengünstig herstellen.

Vorteilhafte Weiterbildungen der Erfindung sind in den Unteransprüchen gekennzeichnet.

Im folgenden wird die Erfindung anhand von in der Zeichnung schematisch dargestellten Ausführungsbeispielen näher erläutert.

In der Zeichnung zeigen:
Figur 1a eine Schnittansicht eines dreischichtigen Elektrodenabschnitts zur Durchführung des erfindungsgemäßen Verfahrens;
Figur 1b eine Schnittansicht eines zweischichtigen Elektrodenabschnitts zur Durchführung des erfindungsgemäßen Verfahrens;
Figur 2 schematisch eine erfindungsgemäße Anordnung zur Herstellung eines leitfähigen strukturierten Polymerfilms;
Figur 3 eine Schnittansicht des Elektrodenabschnitts gemäß Fig. 1b mit darauf abgeschiedenem strukturierten Polymerfilm;
Figur 4 eine Schnittansicht gemäß Figur 3 nach dem Aufbringen eines Substratfilms;
Figur 5 zeigt eine Schnittansicht des mit der Substratschicht abgelösten strukturierten Polymerfilms gemäß Figur 4;
Figur 6 eine Seitenansicht des abgelösten strukturierten Polymerfilms mit Substrat- und Stabilisierungsschicht;
Figur 7 schematisch eine Station zur kontinuierlichen Herstellung eines strukturierten Polymerfilms; und
Figur 8 eine Schnittansicht einer Schichtanordnung für einen Feldeffekt-Transistor;

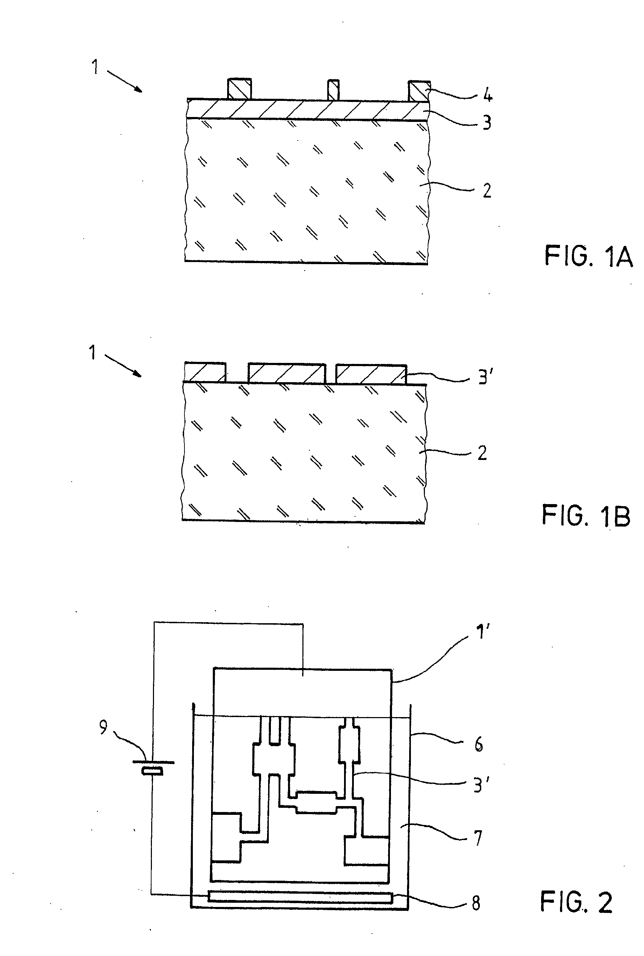

Figur 1a zeigt eine dreischichtige Elektrode, die zur Durchführung des erfindungsgemäßen Verfahrens verwendet wird. Die Elektrode 1 besteht aus drei Schichten. Die unterste Schicht 2 besteht aus einem Trägermaterial, bei diesem Ausführungsbeispiel aus Glas. Die mittlere Schicht 3 ist eine leitfähige Schicht aus Indium-Zinn-Oxid. Diese leitfähige Schicht 3 bedeckt die Trägerschicht 2 vollständig. Auf der leitfähigen Schicht 3 ist auf der der Trägerschicht abgewandten Seite eine Isolatorschicht 4 aufgebracht. Die Isolatorschicht 4 bedeckt die leitfähige Schicht 3 nur in Teilbereichen. In diesen von der Isolatorschicht 4 abgedeckten Teilbereichen wird bei der elektrochemischen Polymerisation kein Polymerfilm abgeschieden. Die Isolatorschicht 4 wird so auf die leitfähige Schicht 3 aufgebracht, daß die frei bleibenden Bereiche der leitfähigen Schicht 3 eine vorgegebene Struktur haben, die der Struktur des zu bildenden Polymerfilms entspricht.

Alternativ zu der in Figur 1a) dargestellten Elektrode kann die in Figur 1b) dargestellte Elektrode verwendet werden. Diese hat lediglich zwei Schichten. Auf der unteren Schicht 2 aus Glas ist wiederum eine leitfähige Schicht 3' aus Indium-Zinn-Oxid (Flächenwiderstand 20 Ω/ 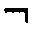 ) aufgetragen. Diese wurde in Teilbereichen mit einem lithographischen Verfahren entfernt. Aus diese Weise kann auch mit zwei Schichten eine Elektrodenoberfläche mit leitfähigen Bereichen einer vorgegebenen Struktur erzeugt werden.

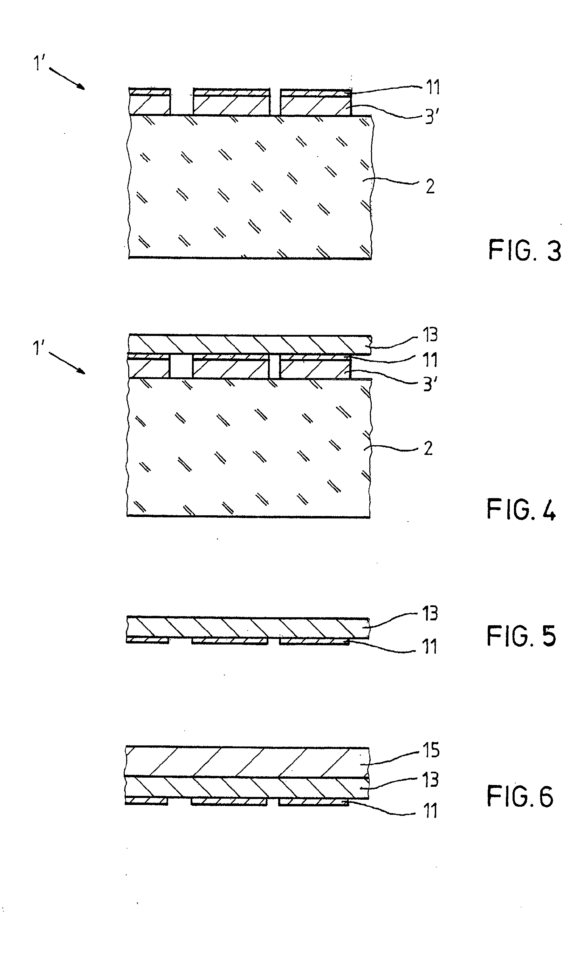

Figur 2 zeigt einen schematischen Aufbau zur Durchführung des erfindungsgemäßen Verfahrens. Bei diesem Ausführungsbeispiel wird ein strukturierter Polymerfilm aus dotiertem Poly(3-Methylthiophen) hergestellt. Die Elektrode 1' gemäß Figur 1b) hängt in einem Behälter 6, der mit einem Elektrolyten 7 gefüllt ist. Der Elektrolyt besteht aus einer Lösung von 0,03M Et₄NBF₄ in trockenem Propylencarbonat. In den Elektrolyten 7 sind 0,2 M 3-Methylthiophene eingebracht. Unterhalb der Anode 1' ist in dem Behälter eine stabförmige Kathode 8 aus Platin angeordnet. Anode 1' und Kathode 8 sind an eine Spannungsquelle 9 angeschlossen. Die strukturierte leitfähige Schicht 3' wird vom Elektrolyten 7 vollständig bedeckt. Beim Einschalten der Spannungsquelle 9 wird eine Spannung von 10 Volt zwischen Anode 1' und Kathode 8 angelegt. Auf den leitfähigen Bereichen findet eine elektrochemische Polymerisation statt und es scheidet sich dabei ein Polymerfilm aus dotiertem Poly(3-Methylthiophen) mit einer den leitfähigen Bereichen der Elektrodenschicht 3' entsprechenden Struktur ab. Sobald der abgeschiedene Polymerfilm die gewünschte Dicke von 0,5 µm hat (nach ca. 30 sec.), kann die Spannung abgeschaltet und die Anode 1' aus dem Elektrolyten herausgeholt werden. Die Anode 1' mit dem auf ihren leitfähigen Bereichen gebildeten strukturierten Polymerfilm 11 ist in Figur 3 abgebildet. Die Leitfähigkeit des hergestellten Poly(3-Methylthiophen)-Filmes liegt im Bereich von 10 S cm⁻¹. Auf die Anode wird nun polymerfilmseitig ganzflächig eine Lösung von in Tetrahydrofuran (16 Gew.%) gelösten Polyvinylchlorid (PVC) aufgebracht. Nach dem Verdunsten des Lösungsmittels Tetrahydrofuran bildet sich die isolierende Substratschicht 13, an der der leitfähige strukturierte (3-Methylthiophen)-Film 11 haftet. Die entsprechende Schichtanordnung aus unterer Schicht 2 aus Glas, leitfähiger Elektrodenschicht 3', leitfähiger strukturierter Polymerschicht 11 und Substratschicht 13 ist in Figur 4 dargestellt. Die Substratschicht 13 wird nun einschließlich des leitfähigen Polymerfilms 11 von der Anode 1' abgezogen. Wie in Figur 5 dargestellt ist, haftet der leitfähige strukturierte Polymerfilm 11 danach nur noch an der Substratschicht 13. Zur Stabilisierung kann auf die dem strukturierten Polymerfilm 11 abgewandte Seite der Substratschicht 13 eine Stabilisierungsschicht aufgebracht werden und die Stabilisierungsschicht 15 mit der Substratschicht 13 thermisch verklebt werden (Figur 6).

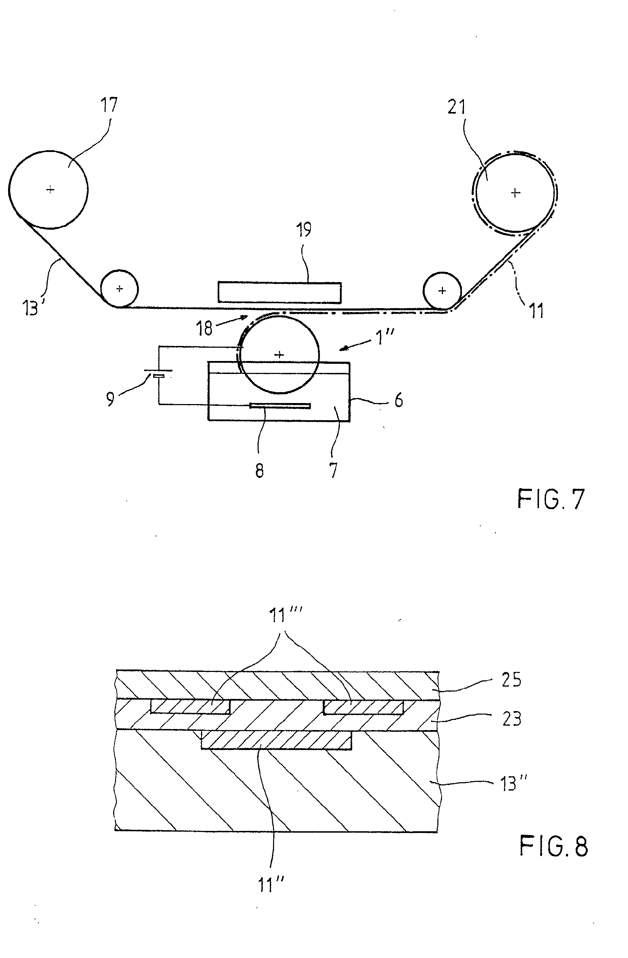

Anhand der Darstellung in Figur 7 wird eine besonders wirtschaftliche Herstellung des leitfähigen strukturierten Polymerfilms 11 beschrieben. Bei diesem Ausführungsbeispiel wird ein strukturierter Polymerfilm aus dotiertem Poly(3,4-Ethylendioxythiophen) hergestellt. Es wird eine kreiszylinderförmige rotierbar aufgehängte Anode 1'' verwendet. Die Anode ist so angeordnet, daß die (nicht dargestellten) leitfähigen Bereiche bei der Rotation der Anode den Elektrolyten 7 durchlaufen. Der Elektrolyt besteht aus einer Lösung von 0,05 M Et₄NBF₄ in trockenem Propylencarbonat. In den Elektrolyten sind 0,05 M 3,4-Ethylendioxythiophen eingebracht.

Eine dünne Substratbahn 13' aus Polymerfolie einer Dicke von 1 mm wird von einer Vorratsrolle 17 abgezogen, umgelenkt und in den Bereich der Anode 1'' bewegt. Im Bereich der Anode 1'' wird, wie bereits beschrieben, schrittweise oder kontinuierlich ein strukturierter Polymerfilm gebildet. Die Leitfähigkeit des hergestellten Poly(3,4-Ethylendioxythiophen) liegt im Bereich von 400 Scm⁻¹. Der strukturierte Polymerfilm wird im Bereich 18 in Kontakt mit der Substratbahn 13' gebracht. In diesem Bereich ist eine Heizvorrichtung 19 vorgesehen, mit deren Hilfe der strukturierte Polymerfilm thermisch mit der Substratbahn verklebt wird. Die Bahn wird danach auf eine Aufwickelrolle 21 aufgewickelt. Auf diese Weise können einfach und kostengünstige große Mengen des strukturierten Polymerfilms erzeugt werden, der eine hohe Auflösung aufweist.

Schließlich können mit dem erfindungsgemäßen Verfahren auch Schichtanordnungen hergestellt werden. Figur 8 zeigt eine Schnittansicht einer Schichtanordnung für einen Feldeffekt-Transistor. Zunächst wird ein leitfähiger strukturierter Polymerfilm 11'' hergestellt, der eine Gate-Elektrodenstruktur enthält. Dieser Polymerfilm 11'' mit der Gate-Elektrodenstruktur wird auf ein Substrat 13'' übertragen. Dann wird ein zweiter leitfähiger strukturierter Polymerfilm 11''' hergestellt, der eine Source- und Drain-Elektrodenstruktur enthält. Auf diesen 2. Polymerfilm 11''' wird noch auf der Anode ein dünner PVC-Film 23 einer Dicke von bspw. 1 µm aufgebracht, vorzugsweise aufgeschleudert, über den der 2. Polymerfilm 11''' dann mit dem 1. Polymerfilm thermisch oder photochemisch verklebt wird. Die Schichtanordnung aus Substratschicht 13'', 1. Polymerfilm 11'', dem dünnen PVC-Film 23 und 2. Polymerfilm 11''' wird danach von der Anode entfernt. Zur Vervollständigung des Transistors wird danach auf den 2. Polymerfilm 11''' bspw. durch Auf schleudern eine Schicht 25 aus einem geeigneten organischen Halbleitermaterial aufgebracht. Beispiele für geeignete organische Halbleitermaterialien sind: Poly(3-hexylthiophen), Poly(thienylenvinylen), Pentacen und alpha-Sexithiophen.

Auf diese Weise können Transistoren schnell, einfach und äußerst kostengünstig hergestellt werden.

Im Rahmen des Erfindungsgedankens sind zahlreiche Abwandlungen möglich. Die Wahl der Materialien der Elektrodenschichten, die Zusammensetzung des Elektrolyten sowie die in den Elektrolyten eingebrachten niedermolekularen Verbindungen können den gewünschten Endstrukturen angepaßt werden. Auch die geometrische Form der Elektroden und die geometrischen Abmessungen der leitfähigen und nichtleitfähigen Bereiche kann beliebig variiert werden. Die leitfähigen Bereiche können mit beliebigen Techniken elektrisch kontaktiert werden. Besonders bewährt hat es sich, wenn der Elektrolyt kontinuierlich während der Ausscheidung gerührt wird. Die Anode mit dem darauf abgeschiedenen strukturierten Polymerfilm kann vor dem Entfernen des Polymerfilms mit Isopropanol gewaschen und mit Stickstoff getrocknet werden. Auch die zum thermischen Verkleben gewählte Temperatur, vorzugsweise 110°C, und die dafür gewählte thermische Behandlungszeit, vorzugsweise 20 Minuten, können beliebig variiert werden. Auch die Schichtanordnungen können frei gewählt werden. Selbstverständlich können auch zwei jeweils auf einer Substratschicht angeordnete strukturierte Polymerfilme miteinander verklebt werden, ggf. unter Verwendung einer oder mehrerer Zwischenschichten. Schließlich können zur elektrochemischen Abscheidung von Metallschichten auch homogene leitfähige Polymerfilme als Zwischenschicht verwendet werden. Es entstehen dann keine strukturierten, sondern ebenfalls homogene Metallfilme. Die homogenen oder strukturierten leitfähigen Polymerfilme können statt elektrochemisch mit beliebigen anderen Verfahren hergestellt werden.

## Patentansprüche

1. Verfahren zur Herstellung eines leitfähigen strukturierten Polymerfilms,
**dadurch gekennzeichnet**,
a) daß eine Elektrode verwendet wird, deren Oberfläche leitfähige Bereiche einer vorgegebenen Struktur und nichtleitfähige Bereiche aufweist,
b) daß wenigstens ein Teil der leitfähigen Bereiche in Kontakt mit einem Elektrolyten gebracht wird, wobei in den Elektrolyten niedermolekulare Verbindungen, vorzugsweise Monomere, eingebracht sind,
c) daß über die Elektrode ein Stromfluß durch den Elektrolyten erzeugt wird, wobei auf den mit dem Elektrolyten in Kontakt gebrachten leitfähigen Bereichen ein leitfähiger Polymerfilm der vorgegebenen Struktur gebildet wird, und
d) daß danach der gebildete strukturierte Polymerfilm von der Elektrode entfernt wird.

2. Verfahren nach Anspruch 1, **dadurch gekennzeichnet, daß** beim Schritt d) der strukturierte Polymerfilm auf ein Substrat übertragen wird.

3. Verfahren nach Anspruch 2, **dadurch gekennzeichnet, daß** zum Übertragen des strukturierten Polymerfilms auf das Substrat auf die Elektrode polymerfilmseitig großflächig, vorzugsweise den gesamten strukturierten Polymerfilm abdeckend, eine nichtleitfähige Substratschicht aufgebracht wird, wobei die Substratschicht so ausgewählt wird, daß der strukturierte Polymerfilm an ihr haftet oder sie mit diesem thermisch oder photochemisch verklebbar ist.

4. Verfahren nach Anspruch 3, **dadurch gekennzeichnet, daß** zur Bildung der nichtleitfähigen Substratschicht eine Lösung aus einem in einem flüchtigen Lösungsmittel gelösten nichtleitfähigen Polymer aufgebracht wird, daß das Lösungsmittel in den gasförmigen Aggregatzustand überführt wird und daß anschließend der an der Substratschicht haftende strukturierte Polymerfilm von der Elektrode abgezogen wird.

5. Verfahren nach Anspruch 3 oder 4, **dadurch gekennzeichnet, daß** eine flexible Substratschicht verwendet wird, die eine Dicke von 50µm bis 1mm, vorzugsweise von 0,4 bis 0,6 mm hat.

6. Verfahren nach einem der Ansprüche 3 bis 5, **dadurch gekennzeichnet, daß** auf die dem strukturierten Polymerfilm abgewandte Seite der Substratschicht eine Stabilisierungsschicht aufgebracht wird und die Stabilisierungsschicht mit der Substratschicht thermisch oder photochemisch verklebt wird.

7. Verfahren nach einem der Ansprüche 1 bis 6, **dadurch gekennzeichnet, daß** die leitfähigen und/oder nichtleitfähigen Bereiche so strukturiert werden, daß wenigstens ein Teil ihrer lateralen Abmessungen unterhalb von 50µm, vorzugsweise unterhalb von 10µm liegt.

8. Verfahren nach einem der Ansprüche 1 bis 7, **dadurch gekennzeichnet, daß** eine wenigstens zweischichtige Elektrode verwendet wird, bei deren Herstellung auf eine untere Schicht aus einem nichtleitfähigen Trägermaterial eine leitfähige Elektrodenschicht ganzflächig aufgebracht wird, die in Teilbereichen zur Bildung der nichtleitfähigen Bereiche entfernt wird.

9. Verfahren nach einem der Ansprüche 1 bis 7, **dadurch gekennzeichnet, daß** eine wenigstens dreischichtige Elektrode verwendet wird, wobei die unterste Schicht aus einem Trägermaterial besteht, auf das eine leitfähige Elektrodenschicht ganzflächig aufgebracht ist, und wobei die leitfähige Elektrodenschicht in Teilbereichen zur Bildung der nichtleitfähigen Bereiche mit einer Isolatorschicht abgedeckt ist.

10. Verfahren nach einem der Ansprüche 1 bis 9, **dadurch gekennzeichnet, daß** als niedermolekulare Verbindungen Pyrrole, 3-Alkylpyrrole, insbesondere 3-Methyl-, 3-Ethyl-, 3-Propylpyrrole, *N*-Alkylpyrrole, insbesondere *N*-Methyl-, *N*-Ethyl-, *N*-Propylpyrrole, *N*-Arylpyrrole, insbesondere *N*-Phenyl-, *N*-(4-Amino)phenyl-, *N*-(4-Methoxy)phenyl-, *N*-Naphtylpyrrole, *N*-Heteroarylpyrrole, insbesondere *N*-(3-Thienyl)-, *N*-(2-Thienyl)-, *N*-(3-Furanyl)-, *N-*(2-Furanyl)-, *N*-(3-Selenophenyl)-, *N*- (2-Selenophenyl)-, *N*-(3-Pyrrolyl)pyrrole, Thiophene, 3-Alkylthiophene, insbesondere 3-Methyl-, 3-Ethyl-, 3-Propylthiophene, Furane, 3-Alkylfurane, 3-Methyl-, 3-Ethyl-, 3-Propylfurane, Selenophene, 3-Alkylselenophene, insbesondere 3-Methyl-, 3-Ethyl-, 3-Propylselenophene, Tellurophene, Aniline, Biphenyle, Azulene, 2-(alpha-Thienyl)thiophene, 2-(alpha-(3-Alkyl)thienyl)thiophene, 2-(alpha-(3-Alkyl)thienyl)-(3-alkyl)thiophene, 2-(alpha-Thienyl)furane, 2-(alpha-(3-Alkyl)thienyl)furane, 2-(alpha-(3-Alkyl)thienyl)-(3-alkyl)furane, 2-(alpha-Thienyl)-(3-alkyl)furane, 2-(alpha-Thienyl)pyrrole, 2-(alpha-(3-Alkyl)thienyl)pyrrole, 2- (alpha-(3-Alkyl)thienyl)-(3-alkyl)pyrrole, 2-(alpha-Thienyl)-(3-alkyl)pyrrole, 2-(alpha-Furanyl)pyrrole, 2-(alpha-(3-Alkyl)furanyl)pyrrole, 2-(alpha-(3-Alkyl)furanyl)-(3-alkyl)pyrrole, 2-(alpha-Furanyl)-(3-alkyl)pyrrole, 2-(alpha-Pyrrolyl)pyrrole, 2-(alpha-(3-Alkyl)pyrrolyl)pyrrole, 2-(alpha-(3-Alkyl)pyrrolyl) - (3-alkyl)pyrrole, 2- (alpha-pyrrolyl) - (3-alkyl)pyrrole, 2-(alpha-Selenophenyl)selenophene, 2-(alpha-(3-Alkyl)selenophenyl)selenophene, 2-(alpha-(3-Alkyl)selenophenyl)-(3-alkyl)selenophene, 2-(alpha-Thienyl) selenophene, 2-(alpha-(3-Alkyl)thienyl)selenophene, 2-(alpha-(3-Alkyl)thienyl)-(3-alkyl)selenophene, 2-(alpha-Thienyl)-(3-alkyl)selenophene, 2-(alpha-Selenophenyl)furane, 2-(alpha-(3-Alkyl)selenophenyl)furane, 2-(alpha-(3-Alkyl)selenophenyl)-(3-alkyl)furane, 2-(alpha-Selenophenyl)-(3-alkyl)furane, 2-(alpha-Selenophenyl)pyrrole, 2-(alpha-(3-Alkyl)selenophenyl)pyrrole, 2-(alpha-(3-Alkyl)selenophenyl)-(3-alkyl)pyrrole, 2-(alpha-Selenophenyl)-(3-alkyl)pyrrole, Thienothiophene, Thienofurane, Thienoselenophene, Thienopyrrole, 2-Phenylthiophene, 2-Phenylfurane, 2-Phenylpyrrole, 2-Phenylselenophene, 2-Phenyltellurophene, N-Vinylcarbazol, N-Ethynylcarbazol, 3,4-Ethylendioxythiophene, 2-(alpha-(3,4-Ethylendioxy)thienyl)thiophene, 2-(alpha-(3,4-Ethylendioxy)thienyl)-3,4-Ethylendioxythiophene, 2-(alpha-(3,4-Ethylendioxy)thienyl)-(3-alkyl)thiophene, 2-(alpha-(3,4-Ethylendioxy)thienyl)furane, 2-(alpha-(3,4-Ethylendioxy)thienyl)-(3-alkyl)furane, 2-(alpha-(3,4-Ethylendioxy)thienyl)pyrrole, 2-(alpha-(3,4-Ethylendioxy)thienyl)-(3-alkyl)pyrrole, 2-(alpha-(3,4-Ethylendioxy)thienyl)selenophene oder 2-(alpha-(3,4-Ethylendioxy)thienyl)-(3-alkyl)selenophene jeweils einzeln oder in beliebiger Kombination oder als oligomere Monomereinheiten verwendet werden.

11. Verfahren nach einem der Ansprüche 1 bis 10, **dadurch gekennzeichnet, daß** der Elektrolyt ein vorzugsweise organisches Lösungsmittel und ein in diesem Lösungsmittel gelöstes Salz enthält, wobei der Elektrolyt so ausgewählt wird, daß die niedermolekularen Verbindungen in ihm löslich sind.

12. Verfahren nach Anspruch 11, **dadurch gekennzeichnet, daß** als Lösungsmittel Propylencarbonat, Acetonitril, einoder mehrwertige Alkohole, Tetrahydrofuran oder Wasser jeweils einzeln oder in beliebiger Mischung verwendet wird.

13. Verfahren nach Anspruch 11 oder 12, **dadurch gekennzeichnet, daß** als Salz Tetraethylammonium-tetrafluoroborat, Tetraethylammonium-hexafluorophosphat, Tetraethylammoniumperchlorat oder Poly(styrolsulfonsäure)-Natriumsalz jeweils einzeln oder in beliebiger Kombination verwendet wird.

14. Verfahren nach einem der Ansprüche 1 bis 13, **dadurch gekennzeichnet, daß** ein strukturierter Polymerfilm einer Dicke von 0,1 bis 2µm, vorzugsweise von 0,4 bis 0,6µm erzeugt wird.

15. Verfahren nach einem der Ansprüche 1 bis 14, **dadurch gekennzeichnet, daß** eine rotierbare vorzugsweise kreiszylinderförmige Elektrode verwendet wird,
daß die Elektrode so angeordnet wird, daß die leitfähigen Bereiche bei der Rotation in den Elektrolyten eintauchen und anschließend aus dem Elektrolyten herausbewegt werden.

16. Verfahren nach einem der Ansprüche 1 bis 15, **dadurch gekennzeichnet, daß** der strukturierte Polymerfilm kontinuierlich oder quasi-kontinuierlich hergestellt wird.

17. Verfahren nach einem der Ansprüche 1 bis 16, **dadurch gekennzeichnet, daß** wenigstens ein Teil des auf der Elektrode gebildeten strukturierten Polymerfilms nach dem Schritt c) in Kontakt mit einer Lösung aus einem Metallsalz gebracht wird, daß über die Elektrode ein Stromfluß durch die Lösung aus dem Metallsalz erzeugt wird, wobei auf dem mit der Lösung aus dem Metallsalz in Kontakt gebrachten strukturierten Polymerfilm ein Metallfilm gebildet wird.

18. Verfahren nach Anspruch 17, **dadurch gekennzeichnet, daß** vor dem Schritt d) auf den Metallfilm auf der dem strukturierten Polymerfilm abgewandten Seite ein Substrat aufgebracht wird.

19. Verwendung des Verfahrens nach einem der Ansprüche 1 bis 18 zur Herstellung einer Source- und Drain-Elektroden wenigstens eines Feldeffekttransistors enthaltenden Leiterstruktur.

20. Verwendung nach Anspruch 19, **dadurch gekennzeichnet, daß** die Source- und Drain-Elektroden derart angeordnet werden, daß sich eine Kanallänge von 2 bis 50µm, vorzugsweise von 10µm, ergibt.
